# EUROPEAN PATENT APPLICATION

(11) **EP 2 071 630 A1**
(43) Date of publication of application: **17.06.2009**
(21) Application number: 07807228.7
(22) Date of filing: 13.09.2007
(51) Int. Cl.: H01L 29/786, H01L 21/336

(54) **THIN FILM TRANSISTOR, METHOD FOR MANUFACTURING THE SAME, AND DISPLAY**

(30) Priority: 02.10.2006 JP 2006270359
(71) Applicant: Sony Corporation, Tokyo 108-0075 (JP)
(72) Inventor: NAKAYAMA, Tetsuo, Tokyo 108-0075 (JP)
(74) Representative: Müller - Hoffmann & Partner
(86) International application number: PCT/JP2007/067821
(87) International publication number: WO 2008/041462

(57) **Abstract**

Disclosed is a thin film transistor which is **characterized by** including a gate electrode 3, a gate insulating film 4, a channel layer 5 and source/drain layers 7, 8 stacked over a substrate 2 in this order or in reverse order, wherein the source/drain layers 7, 8 include n-type microcrystalline silicon layers 7a, 8a and n-type amorphous silicon layers 7b, 8b, which are so arranged that the n-type microcrystalline silicon layers 7a, 8a are on the channel layer 5 side. Also disclosed are a method for manufacturing such a thin film transistor and a display.

## Description

### Technical Field

The present invention relates to a thin film transistor, a method for manufacturing the same, and a display, particularly to a thin film transistor suitably used for driving a current-driven type element such as an organic EL element, a method for manufacturing the same, and a display.

### Background Art

In recent years, as one of flat panel displays, a display operative to display images by utilizing the organic EL (electro luminescence) phenomenon has been paid attention to. This type of display, i.e., the organic EL display has excellent features such as a wide angle of visibility, owing to the utilization of a light emission phenomenon of the organic light emitting element itself, and a small power consumption. Further, the organic EL display exhibits a high response to high-definition high-speed video signals. For these reasons, development of the organic EL displays in an attempt to put them to practical use is being advanced, particularly in video fields and the like.

Of driving systems for organic EL displays, the active matrix system in which driving elements based on thin film transistors (TFTs) are used is superior in response and resolution, as compared with the passive matrix system in the related art, and is considered to be a driving system particularly suitable for the organic EL displays having the above-mentioned features.

An organic EL display of the active matrix system includes a driving panel provided with organic light emitting elements (organic EL elements) having at least an organic light emitting material and driving elements (thin film transistors (TFTs)) for driving the organic light emitting elements, and the driving panel and a sealing panel are adhered to each other through an adhesive layer therebetween, in such a manner as to sandwich the organic light emitting elements therebetween.

As thin film transistors constituting an organic EL display of the active matrix type, at least switching transistors for controlling the brightness of pixels and driving transistors for controlling the light emission of the organic EL elements are needed.

The thin film transistor is known to be shifted in threshold voltage when a condition where a voltage is impressed on the gate electrode thereof is continued. However, the driving transistors in an organic EL display have to be kept in the current passing state as long as the relevant organic EL elements are emitting light. Therefore, the driving transistors in the organic EL display are susceptible to shifts in the threshold voltage. If the threshold voltage of the driving transistor is shifted, the current flowing through the driving transistor would be varied, resulting in a change in the luminance of the light emitting element constituting the relevant pixel.

In recent years, in order to alleviate the threshold shift in the driving transistors, an organic EL display in which driving transistors having a channel region including a crystalline silicon semiconductor layer are used has also been developed.

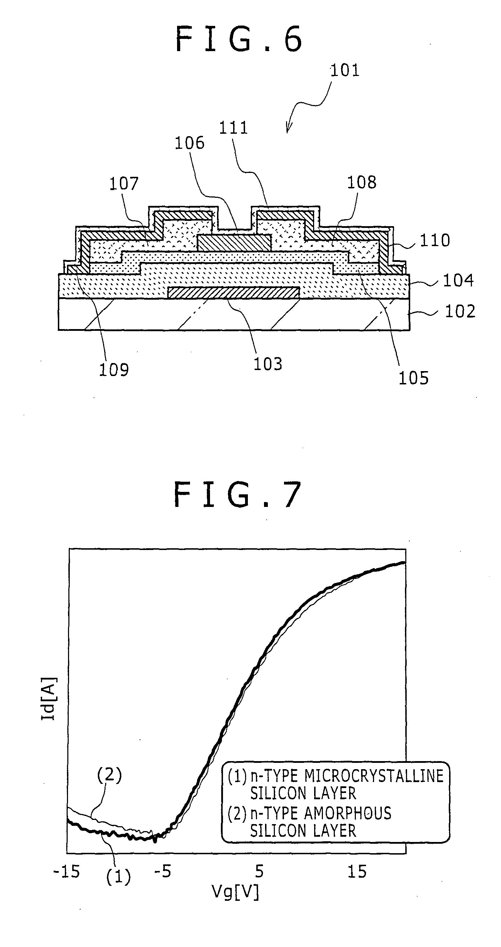

Here, an example of the structure of a thin film transistor used for organic EL elements of the active matrix system is shown in FIG. 6. The thin film transistor 101 shown in the figure is a bottom-gate n-channel type (n-type) thin film transistor in which a gate insulating film 104 including silicon nitride is formed in the state of covering a gate electrode 103 formed and patterned over a substrate 102 including a glass or the like. Over the gate insulating film 104, a channel layer 105 including amorphous silicon or microcrystalline silicon is formed in the state of covering the gate electrode 103.

Over the channel layer 105, in addition, a channel protecting layer 106 is arranged on the upper side of a central area of the gate electrode 103. A source layer 107 and a drain layer 108 are formed and patterned, in a mutually separated state, over the channel layer 105 so as to cover the upper side of both end portions of the channel protecting layer 106. Further, a source electrode 109 and a drain electrode 110 partly stacked on the source layer 107 and the drain layer 108, respectively, are formed and patterned over the gate insulating film 104. Besides, a passivation film 111 is provided in the state of entirely covering the face side of the substrate 102 in this condition.

In the thin film transistor as above, an n-type amorphous silicon layer or n-type microcrystalline silicon layer in which an n-type impurity is contained is widely used for forming the source/drain layers 107 and 108. Here, measurement results of current-voltage characteristic in the case where an amorphous silicon layer is singly used to form the source/drain layers 107 and 108 and the case where a microcrystalline silicon layer is singly used to form the source/drain layers 107 and 108 are shown in FIG. 7.

It is seen from this graph that the thin film transistor using the n-type microcrystalline silicon layer to form the source/drain layers 107 and 108 has a lower OFF current, as compared with the case of using the n-type amorphous silicon layer.

Here, as an example of the use of a microcrystalline silicon layer to form source/drain layers, an example has been reported in which a channel protecting layer is formed over a gate insulating film, with a microcrystalline silicon layer therebetween, and those portions of the microcrystalline layer which are protruding from the channel protecting layer are converted to n-type (refer to, for example, Patent Document 1). Also, an example has been proposed in which source/drain layers (ohmic contact layers) each have two layers, i.e., a microcrystalline silicon layer and an amorphous layer, of which the n-type amorphous silicon layer is arranged on the channel layer side (refer to, for example, Patent Document 2).

Patent Document 1: Japanese Patent Laid-open No. Hei 7-193249
Patent Document 2: Japanese Patent Laid-open No. Hei 8-172195

### Disclosure of Invention

### Technical Problems

However, in the thin film transistor using the n-type microcrystalline silicon layer to form the source/drain layers (n⁺-type semiconductor layers) as described in Patent Document 1, the channel layer and the source/drain layers include the same layer, and they are mutually connected in the manner of n-type microcrystalline silicon - microcrystalline silicon - n-type microcrystalline silicon to form a current leak path, resulting in a higher OFF current. In addition, the thin film transistor wherein the source/drain layers each include two layers, i.e., an n-type microcrystalline silicon layer and an n-type amorphous silicon layer and the n-type amorphous silicon layer is arranged on the channel layer side as described in Patent Document 2 has a problem in that the OFF current is high, a sufficient ON current cannot be obtained, and a sufficient carrier mobility cannot be obtained.

In view of the foregoing, it is an object of the present invention to provide a thin film transistor showing a high ON/OFF ratio and an improved carrier mobility, a method for manufacturing such a thin film transistor, and a display.

### Technical Solution

In order to attain the above object, according to the present invention, there is provided a thin film transistor including a gate electrode, a gate insulating film, a channel layer, and source/drain layers stacked over a substrate in this order or in reverse order, wherein the source/drain layers each include a microcrystalline silicon layer and an amorphous silicon layer, which are so arranged that the microcrystalline silicon layer is on the channel layer side.

According to the thin film transistor as just-mentioned, the source/drain layers each include the microcrystalline silicon layer and the amorphous silicon layer, which are so arranged that the microcrystalline silicon layer is on the channel layer side. As will be described in detail in the mode for carrying out the invention, the thin film transistor with this configuration has been confirmed to show a reduced OFF current and an increased ON current, as compared with the thin film transistors which have been described in Background Art above, i.e., the thin film transistor having the source/drain layers each including a single layer composed of a microcrystalline silicon layer and the thin film transistor having the source/drain layers of the two-layer structure including a microcrystalline silicon layer and an amorphous silicon layer.

In addition, according to the present invention, there are also provided methods for manufacturing such a thin film transistor as above-mentioned. In a first manufacturing method, first, a gate insulating film is formed over a substrate, with a gate electrode therebetween. Next, a channel layer is formed over the gate insulating layer. Subsequently, source/drain layers each including a microcrystalline layer and an amrohpus silicon layer which are sequentially stacked are formed over the channel layer.

According to the first manufacturing method as above, there is formed a thin film transistor of the bottom gate type in which the source/drain layers are stacked over the gate insulating film covering the gate electrode, with the channel layer therebetween, wherein the source/drain layers each have a two-layer structure in which the microcrystalline silicon layer and the amorphous silicon layer are arranged so that the microcrystalline silicon layer is on the channel layer side.

Further, in a second manufacturing method according to the present invention, first, source/drain layers each having an amorphous silicon layer and a microcrystalline silicon layer stacked sequentially are formed over a substrate. Next, a channel layer is formed over the source/drain layers. Subsequently, a gate electrode is formed over the channel layer, with a gate insulating film therebetween.

According to the second manufacturing method as above, there is formed a thin film transistor of the top gate type in which the channel layer stacked over the source/drain layers is covered with the gate insulating film and the gate electrode is provided over the gate insulating film, wherein the source/drain layers each have a two-layer structure in which the microcrystalline silicon layer and the amorphous silicon layer are arranged so that the microcrystalline silicon layer is on the channel layer side.

Furthermore, according to the present invention, there is provided a display including the thin film transistor. The display is characterized by including a substrate over which thin film transistors and display elements connected to the thin film transistors are formed in an arrayed manner, each of the thin film transistors including a gate electrode, a gate insulating film, a channel layer, and source/drain layers stacked over the substrate in this order or in reverse order, wherein the source/drain layers each include a microcrystalline silicon layer and an amorphous silicon layer, which are so arranged that the microcrystalline layer is on the channel layer side.

According to the display as above, the presence of the thin film transistors promises a reduced OFF current and an increased ON current.

### Advantageous Effects

According to the thin film transistor and the display including the thin film transistors of the present invention, the OFF current of the thin film transistors is reduced and the ON current of the thin film transistors is increased, so that the ON/OFF ratio can be increased and, due to the increase in the ON current, carrier mobility can be enhanced. Therefore, the electric characteristics of the thin film transistors can be enhanced, and the performance of the display can be enhanced.

In addition, according to the methods for manufacturing a thin film transistor of the present invention, it is possible to obtain a thin film transistor showing an increased ON/OFF ratio and an enhanced carrier mobility.

### Brief Description of Drawings

[FIG. 1]

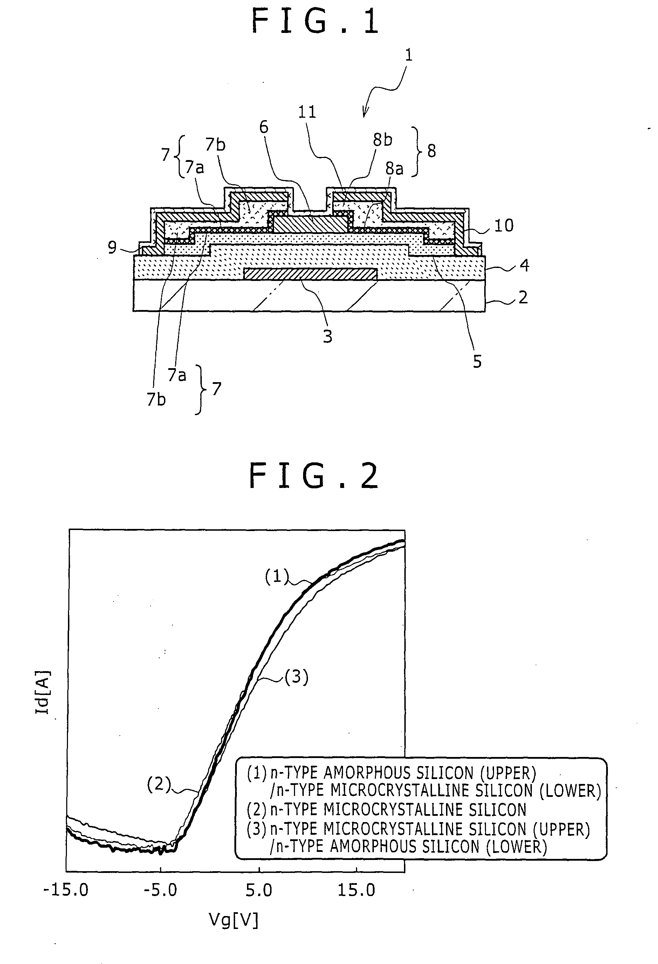

   FIG. 1 is a sectional view showing the configuration of a thin film transistor according to a first embodiment of the present invention.
[FIG. 2]
   FIG. 2 is a graph showing the current-voltage characteristic of a thin film transistor according to the first embodiment of the present invention.
[FIG. 3]

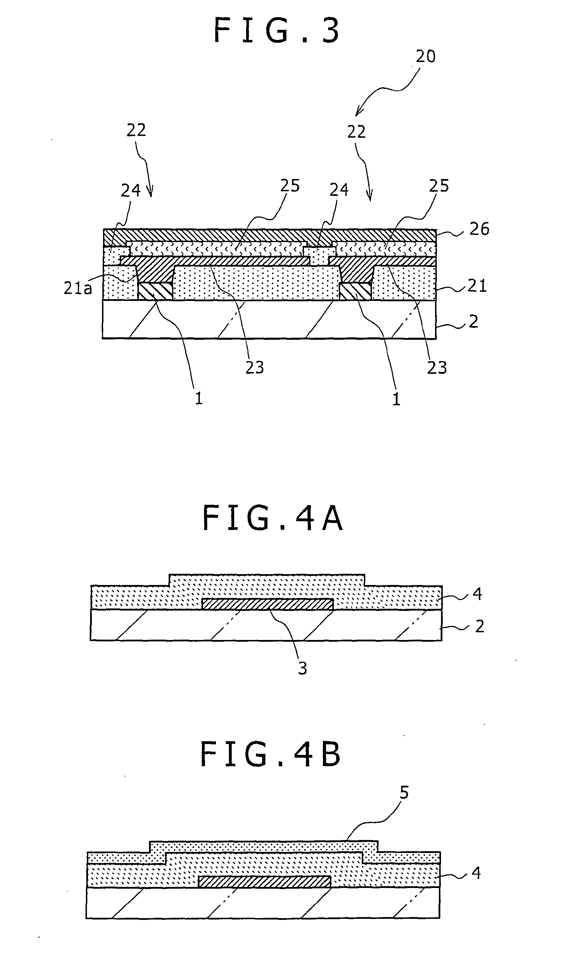

   FIG. 3 is a sectional view showing the configuration of a display including the thin film transistors according to the first embodiment of the present invention.
[FIG. 4A]
   FIG. 4A is a manufacturing step sectional view (No. 1) showing a method for manufacturing the thin film transistor according to the first embodiment of the present invention.
[FIG. 4B]
   FIG. 4B is a manufacturing step sectional view (No. 2) showing the method for manufacturing the thin film transistor according to the first embodiment of the present invention.
[FIG. 4C]

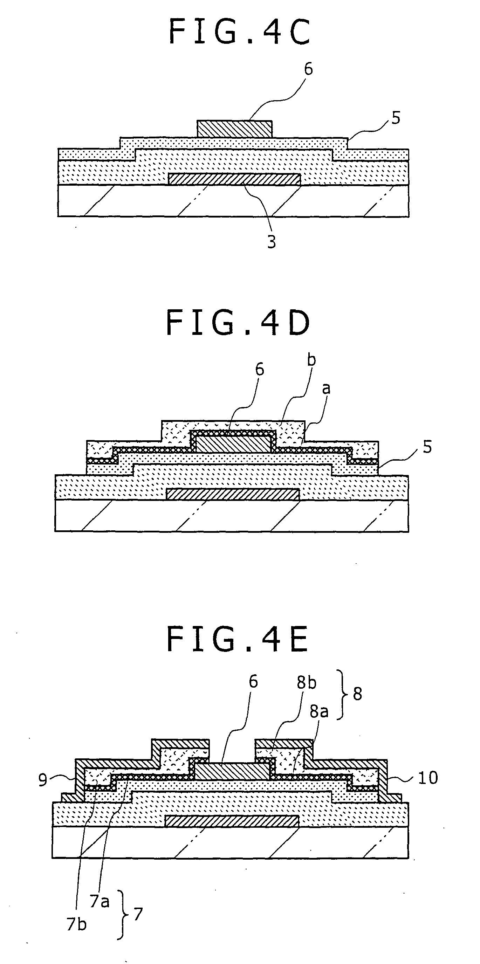

   FIG. 4C is a manufacturing step sectional view (No. 3) showing the method for manufacturing the thin film transistor according to the first embodiment of the present invention.
[FIG. 4D]
   FIG. 4D is a manufacturing step sectional view (No. 4) showing the method for manufacturing the thin film transistor according to the first embodiment of the present invention.
[FIG. 4E]
   FIG. 4E is a manufacturing step sectional view (No. 5) showing the method for manufacturing the thin film transistor according to the first embodiment of the present invention.
[FIG. 4F]

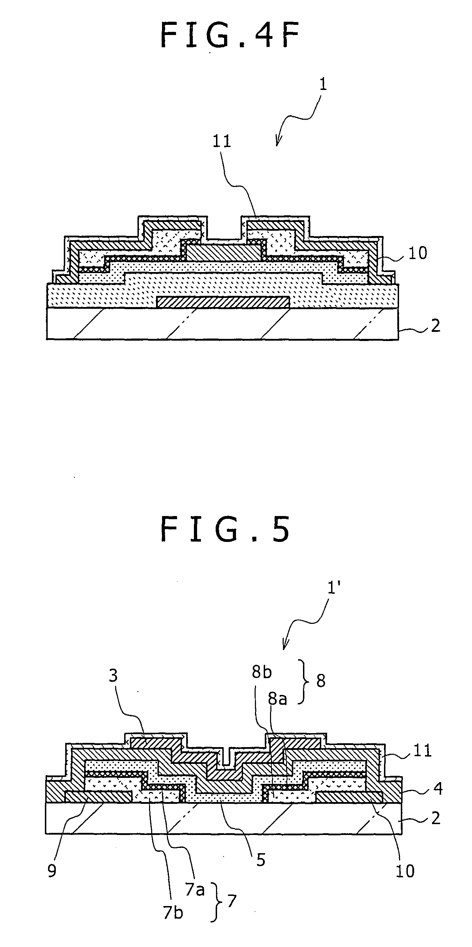

   FIG. 4F is a manufacturing step sectional view (No. 6) showing the method for manufacturing the thin film transistor according to the first embodiment of the present invention.
[FIG. 5]
   FIG. 5 is a sectional view showing the configuration of a thin film transistor according to a second embodiment of the present invention.
[FIG. 6]
   FIG. 6 is a sectional view showing the configuration of a thin film transistor according to the related art.
[FIG. 7]
   FIG. 7 shows a graph showing the current-voltage characteristics of thin film transistors using an n-type microcrystalline silicon layer or an n-type amorphous silicon layer for forming source/drain layers.

### Best Mode for Carrying Out the Invention

Now, embodiments of the present invention will be described in detail below.

### (First Embodiment)

FIG. 1 is a sectional configuration view illustrating a thin film transistor according to a first embodiment of the present invention. The thin film transistor 1 shown in this figure is a bottom-gate n-type thin film transistor, in which a belt-like gate electrode 3 including molybdenum, for example, is formed and patterned over a substrate 2 including a glass or other insulating substrate. The material of the gate electrode 3 is not particularly limited, and may be other than molybdenum insofar as it is a high melting point metal that is insusceptible to denaturing under heat during a crystallizing step.

In addition, a gate insulating film 4 including a silicon oxide film, for example, is formed in the state of covering the gate electrode 3. The gate insulating film 4 is not limited to the silicon oxide film and may be a silicon nitride film, a silicon oxynitride film or a laminate film of these.

Further, a channel layer 5 including amorphous silicon, for example, is formed and patterned in the state of covering the gate electrode 3. Incidentally, the channel layer 5 may include microcrystalline silicon. A channel protecting layer 6 including an insulating material such as a silicon nitride film, for example, is provided over the channel layer 5 at a position on the upper side of the gate electrode 3. The channel protecting layer 6 functions as an etching stopper layer at the time of forming and patterning, by etching, source/drain layers which are formed over the channel protecting layer 6 in a manufacturing method to be described later. With the channel protecting layer 6 thus provided, the channel layer 5 is prevented from being corroded due to the etching. As the channel protecting layer 6, the silicon nitride film and may be a silicon oxide film, a silicon oxynitride film or a laminate film of these are used.

Incidentally, while an example in which the channel protecting layer 6 is provided over the channel layer 5 at a position on the upper side of the gate electrode 3 has been described here, the present invention is applicable also to the case where the channel protecting layer 6 is not provided.

In addition, a source layer 7 and a drain layer 8 which are mutually separate from each other and which are partly stacked respectively over both end portions of the channel protecting layer 6 are formed and patterned over the channel layer 5. A characteristic feature of the present invention resides in that the source/drain layers 7 and 8 have a two-layer structure in which microcrystalline silicon layers (n-type microcrystalline silicon layers) 7a, 8a containing an n-type impurity (e.g., phosphorus) and amorphous silicon layers 7b, 8b containing an n-type impurity (e.g., phosphorus) are sequentially stacked. This results in that the n-type microcrystalline silicon layers 7a, 8a are arranged on the channel layer 5 side.

Besides, a source electrode 9 and a drain electrode 10 which are partly stacked respectively over the source layer 7 and the drain layer 8 are formed and patterned over the gate insulating film 4. In addition, a passivation film 11 is provided in the state of entirely covering the face side of the substrate 2 in this condition.

Here, the results of measurement of gate voltage (Vg) - drain current (Id) characteristic (Vds = +10 V) for the thin film transistor configured as above are shown in FIG. 2.

Here, graph (1) is the measurement results for the thin film transistor having the source/drain layers 7, 8 of the two-layer structure in which the n-type microcrystalline silicon layer 7a is arranged on the channel layer 5 side (lower side) and the n-type amorphous silicon layer 7b is arranged on the source/drain electrode 9, 10 side (upper side) as described in the first embodiment above. In this thin film transistor, the thickness of the n-type microcrystalline silicon layer was adjusted to 10 nm, and the thickness of the n-type amorphous silicon layer was adjusted to 90 nm.

In addition, graph (2) is the measurement results for a thin film transistor having source/drain layers of a two-layer structure in which n-type amorphous silicon layers are arranged on the channel layer side and n-type microcrystalline silicon layers are arranged on the source/drain electrode side. In this thin film transistor, also, the thickness of the n-type microcrystalline silicon layer was adjusted to 10 nm, and the thickness of the n-type amorphous silicon layer was adjusted to 90 nm. Further, graph (3) is the measurement results for a thin film transistor having source/drain layers each of which includes an n-type microcrystalline silicon layer as a single layer. In this thin film transistor, the thickness of the n-type microcrystalline silicon layer was adjusted to 100 nm.

Incidentally, in measurement of the drain current for each of the thin film transistors, the drain current was monitored while continuously shifting the gate voltage in the minus direction and in the plus direction. In addition, Table 1 below shows ON current, OFF current, and carrier mobility (relative values) for the thin film transistors having the source/drain layers of the two-layer structures shown in graphs (1) and (2), wherein the corresponding characteristics of the thin film transistor using only the n-type microcrystalline silicon layer to form the source/drain layers are assumed to be 1.

**[Table 1]**

| Upper part | n-type amorphous silicon layer | n-type microcrystalline silicon layer | n-type micro-crystalline silicon layer |
|---|---|---|---|
| Lower part | n-type microcrystalline silicon layer | n-type amorphous silicon layer | |
| Mobility | 1.38 | 1.08 | 1.00 |
| ON current | 1.29 | 0.93 | 1.00 |
| OFF current | 0.88 | 2.00 | 1.00 |
| OFF current (minimum) | 0.80 | 1.39 | 1.00 |
| Graph | (1) | (2) | (3) |

First, graphs (1) to (3) in FIG. 2 and the measurement results given in Table 1 show the following. In the measurement results for the thin film transistor of (1) manufactured by applying the present invention, a reduced OFF current and an increased ON current were confirmed, as compared to those in the measurement results for the thin film transistors of (2) and (3) manufactured without application of the present invention. Consequently, it was confirmed that the thin film transistor of (1) was increased in ON/OFF ratio, as compared with the thin film transistors of (2) and (3). Besides, it was confirmed that in the thin film transistor of (1), the carrier mobility was enhanced due to the increase in the ON current.

Thus, it has been confirmed that ON/OFF ratio is increased and an enhanced carrier mobility is obtained according to the thin film transistor in the present embodiment. Therefore, electric characteristics of the thin film transistor can be enhanced.

Now, a configuration example of a display using the thin film transistor 1 as above will be described below, taking an organic EL display as an example and referring to FIG. 3. Incidentally, in FIG. 3, detailed configuration of the thin film transistor 1 is omitted.

The display 20 has a configuration in which an inter-layer insulating film 21 covers the side, on which the thin film transistors 1 are formed, of a substrate 2, and light emitting elements (here, organic EL elements) 22 connected respectively to the thin film transistors 1 are formed over the inter-layer insulating film 21 in an arrayed manner. The organic EL elements 22 each have a lower electrode 23 connected to the thin film transistor 1 through a connection hole 21a formed in the inter-layer insulating film 21. The lower electrodes 23 are patterned on a pixel basis, and each of them has a peripheral portion covered by an insulating film pattern 24 so that only its central portion is widely exposed. In addition, over the exposed portion of each lower electrode 23, an organic layer 25 having at least a light emitting layer is stacked in a patterned state. The light emitting layer has an organic material which permits light emission to arise from recombination of holes and electrons injected into the light emitting layer. On the upper side of the organic layers 25 and the insulating film patterns 24 patterned in this manner, an upper electrode 26 is arranged in the state of being securely insulated from the lower electrodes 23.

In this display 20, the lower electrodes 23 are used as anodes (or negative electrodes), and the upper electrode 26 is used as a cathode (or an anode). Holes and electrons are injected from the lower electrode 23 and the upper electrode 26 into the organic layer 25 sandwiched between the lower electrode 23 and the upper electrode 26, whereby light emission is induced in a light emitting layer portion of the organic layer 25. Incidentally, where the display 20 is of the upper side light emission type in which emitted light is picked up on the upper electrode 26 side, the upper electrode 26 is formed by use of a highly light-transmitting material. On the other hand, where the display 20 is of the transmission type in which emitted light is picked up on the substrate 2 side, the substrate 2 and the lower electrodes 23 are formed by use of highly light-transmitting materials.

According to the display 20 configured as above, the thin film transistors 1 configured as described above referring to FIG. 1 are connected to the organic EL elements 22, whereby the ON/OFF ratio of the thin film transistors 1 can be increased, and carrier mobility can be enhanced. Consequently, a display with enhanced performance can be attained.

In addition, though omitted in the drawing, in a pixel circuit in the display 20 using the organic EL elements 22, at least two transistors, i.e., a switching transistor and a driving transistor for controlling the light emission of the organic EL element 22, are needed for each pixel. Of the two transistors, the driving transistor has to have a reduced OFF current; otherwise, irregularities in luminance would be generated and picture quality would be worsened. In this connection, however, the thin film transistor 1 used as the driving TFT shows a reduced OFF current, as above-mentioned, and it is therefore possible to enhance the uniformity of picture quality in the display screen.

Incidentally, while description here has been made using an example in which the display 20 is an organic EL display, the display 20 is not limited to the organic EL display, and may be a liquid crystal display, for example. It is to be noted, however, that the above-mentioned advantageous effects can be obtained when the above-described thin film transistor is used, particularly as the driving transistor, in manufacturing the organic EL display, and such a use is therefore favorable.

### <Manufacturing Method>

Now, a method for manufacturing the thin film transistor 1 configured as above-described and a subsequent method for manufacturing the display will be described below.

First, as shown in FIG. 4A, a molybdenum film is formed in a thickness of 100 nm over a substrate 2 including an insulating substrate, and ordinary photolithography and etching are conducted, to form and pattern a gate electrode 3. Thereafter, a gate insulating film 4 including silicon oxide is formed in a thickness of, for example, 160 nm over the substrate 2 in the state of covering the gate electrode 3 by a plasma CVD process.

Next, as shown in FIG. 4B, a channel layer 5 including amorphous silicon, for example, is formed in a thickness of 30 nm over the gate insulating film 4. Incidentally, in the case where a microcrystalline silicon layer is used as the channel layer 5, the amorphous silicon layer formed in this manner may be made to be microcrystalline by such a method as laser annealing.

Subsequently, as shown in FIG. 4C, a silicon nitride film is formed in a thickness of 200 nm over the gate insulating film 4 in the state of covering the channel layer 5, and ordinary photolithography and etching are conducted, whereby a channel protecting layer 6 is formed and patterned over the channel layer 5 in an area on the upper side of the gate electrode 3. The etching here may be wet etching conducted by use of a solution including hydrofluoric acid, for example.

Next, an n-type microcrystalline silicon layer a containing an n-type impurity and an n-type amorphous silicon layer b containing an n-type impurity are formed in this order over the channel layer 5 in the state of covering the channel protecting layer 6 by, for example, a plasma CVD process using monosilane and hydrogen as film-forming gases and using phosphine as an n-type impurity. Incidentally, in the case of forming the n-type microcrystalline silicon layer, the flow rate ratio of hydrogen to monosilane is set to be higher than that in a condition of forming the n-type amorphous silicon layer, to promise easier microcrystallization of the n-type silicon layer.

Incidentally, the thicknesses of the n-type microcrystalline silicon layer a and the n-type amorphous silicon layer b may have any value on such a level that the layers can be formed with good coverage, for example, not less than 10 nm. As an example, here, the thickness of the n-type microcrystalline silicon film 7a is 10 nm, and the thickness of the n-type amorphous silicon layer 7b is 90 nm.

Besides, in the case of conducting such a continuous film-forming process, a control may be carried out so that the crystal state (crystallinity) will continuously vary over the range from the n-type microcrystalline silicon layer a to the n-type amorphous silicon layer b. Consequently, the n-type microcrystalline silicon layer a and the n-type amorphous silicon layer b are formed as films stacked (laminated) continuously.

Thereafter, as shown in FIG. 4D, photolithography and etching steps are carried out, whereby the n-type amorphous silicon layer b, the n-type microcrystalline silicon layer a, and the channel layer 5 therebeneath are patterned into an island-like pattern. In this case, a contact hole (omitted in the drawings) for connection to the gate electrode 3 is formed.

Next, as shown in FIG. 4E, a three-layer metallic layer including titanium/aluminum/titanium, for example, is formed in a thickness combination of 50 nm/100 nm/50 nm in the state of covering the n-type amorphous silicon layer b, the n-type microcrystalline silicon layer a and the channel layer 5 patterned as above, and photolithography and etching steps are carried out, to form a source electrode 9 and the drain electrode 10 which include the three-layer metallic layer. In this case, over the channel layer 5 on the upper side of a central portion of the gate electrode 3, the source electrode 9 and the drain electrode 10 are separated from each other, and the n-type amorphous silicon layer b and the n-type microcrystalline silicon layer a are patterned, to form a source layer 7 and a drain layer 8. As a result, the source layer 7 is in the state in which an n-type microcrystalline silicon layer 7a and an n-type amorphous silicon layer 7b are stacked in this order, and the drain layer 8 is in the state in which an n-type microcrystalline silicon layer 8a and an n-type amorphous silicon layer 8b are stacked in this order. Besides, in this etching, the channel protecting layer 6 functions as an etching stopper layer.

Thereafter, as shown in FIG. 4F, a passivation film 11 including a silicon nitride film, for example, is formed in a thickness of 200 nm in the state of entirely covering the upper side of the substrate 2 in this condition. Subsequently, a contact hole (omitted in the drawings) for connection to the drain electrode 10 is formed.

In the case of manufacturing a display having the thin film transistors 1 as above-described, the following steps are subsequently carried out. First, as shown in FIG. 3, the substrate 2 provided with the thin film transistors 1 is covered with an inter-layer insulating film 21, and connection holes 21a connected to the thin film transistors 1 are formed in the inter-layer insulating film 21. Thereafter, lower electrodes 23 connected to the thin film transistors 1 through the connection holes 21a are formed and patterned over the inter-layer insulating film 21. Next, the peripheries of the lower electrodes 23 are covered with insulating film patterns 24, and then an organic layer 25 including at least a light emitting layer is formed over each of the lower electrodes 23 exposed from the insulating film patterns 24. Next, an upper electrode 26 is formed in the state of covering the organic layers 25 and the insulating film patterns 24. By this, organic EL elements 22 connected to the thin transistors 1 through the lower electrodes 23 are formed.

By the manufacturing methods as above, the thin film transistor 1 and the display using the same in the first embodiment of the present invention can be manufactured.

### <Second Embodiment>

### (Thin Film Transistor)

FIG. 5 is a sectional view illustrating a thin film transistor according to a second embodiment of the present invention. The thin film transistor 1' shown in the figure is a top-gate type tin film transistor, in which a source layer 7 and a drain layer 8 are provided in the state of being stacked respectively over a source electrode 9 and a drain electrode 10 formed and patterned over a substrate 2. The source layer 7 and the drain layer 8 each have a stacked (laminate) structure characteristic of the present invention. Specifically, the source layer 7 has a two-layer structure configured to include an n-type amorphous silicon layer 7b covering the source electrode 9 and an n-type microcrystalline silicon layer 7a on the upper side thereof. The drain layer 8 has a two-layer structure configured to include an n-type amorphous silicon layer 8b covering the drain electrode 10 and an n-type microcrystalline silicon layer 8a on the upper side thereof.

In addition, a channel layer 5 is provided in the state of having both its ends stacked respectively on end portions of the source layer 7 and the drain layer 8. Further, a gate electrode 3 is formed over the channel layer 5, with a gate insulating film 4 therebetween. Besides, a passivation film 11 is provided to entirely cover the face side of the substrate 2 in this condition.

Also in the thin film transistor 1' configured as above, in the same manner as in the first embodiment, the source/drain layers 7 and 8 are of the two-layer structure in which the n-type microcrystalline silicon layers 7a, 8a are arranged on the channel layer 5 side, and the n-type amorphous silicon layers 7b, 8b are arranged on the source/drain electrode 9, 10 side. With this configuration, it is possible to obtain the same advantageous effects as those of the thin film transistor 1 in the first embodiment.

### (Display)

Examples of the configuration of a display using the thin film transistor 1' as above include the configuration of the display described above referring to FIG. 3, whereby it is possible to obtain the same advantageous effects as those in the first embodiment.

### (Manufacturing Method)

Now, a method for manufacturing the thin film transistor 1' configured as above-described and a subsequent method for manufacturing the display will be described below.

First, a source electrode 9 and a drain electrode 10 are formed and patterned.

Next, an n-type amorphous silicon layer is formed by a plasma CVD process, and then an n-type microcrystalline silicon layer is formed over the n-type amorphous silicon layer. Incidentally, the formation of the n-type amorphous silicon layer and the formation of the n-type microcrystalline silicon layer as above may be carried out continuously. In the case of performing such a continuous film-forming process, a control of the film forming condition may be carried out so that the crystal state (crystallinity) will be continuously varied over the range from the n-type amorphous silicon layer to the n-type microcrystalline silicon layer. As a result, the n-type amorphous silicon layer and the n-type microcrystalline silicon layer for constituting source/drain layers to be described later are formed as continuously stacked (laminated) films. Thereafter, these layers are patterned, to form the source/drain layers 7, 8 in which the n-type amorphous silicon layers 7b, 8b and the n-type microcrystalline silicon layers 7a, 8a are stacked in this order.

Next, a channel layer 5 including an amorphous silicon not containing an impurity is formed in the state of covering the source layer 7 and the drain layer 8 and, further, covering the source electrode 10 and the drain electrode 11.

Subsequently, the channel layer 5 is patterned into an island-like pattern. As a result, a configuration in which both ends of the channel layer 5 are stacked respectively on the source layer 7 and the drain layer 8 is obtained. Thereafter, a gate insulating film 4 including silicon oxide is formed in the state of covering the channel layer 5 by, for example, a plasma CVD process.

Next, a gate electrode 3 is formed and patterned over the channel layer 5 in the state of having its both end stacked respectively on the source layer 7 and the drain layer 8. Thereafter, a passivation film 11 is formed over the gate insulating film 4 in the state of covering the gate electrode 3.

In this manner, the thin film transistor 1' of the top gate structure is formed.

The subsequent steps in the case of manufacturing the display using the above-described thin film transistors 1' are carried out in the same manner as the steps described in the first embodiment above.

In the manner as above, the thin film transistor 1' and the display using the same according to the second embodiment of the present invention can be manufactured.

## Claims

1. A thin film transistor is **characterized by** comprising a gate electrode, a gate insulating film, a channel layer, and source/drain layers stacked over a substrate in this order or in reverse order,
wherein said source/drain layers each include a microcrystalline silicon layer and an amorphous silicon layer, which are so arranged that said microcrystalline silicon layer is on the channel layer side.

2. The thin film transistor according to claim 1,
wherein said thin film transistor is **characterized** that it is of n-channel type.

3. A method for manufacturing a thin film transistor, is **characterized by** comprising:
a step of forming a gate insulating film over a substrate, with a gate electrode therebetween;
a step of forming a channel layer over said gate insulating layer; and
a step of forming source/drain layers each including a microcrystalline silicon layer and an amorphous silicon layer sequentially stacked over said channel layer.

4. A method for manufacturing a thin film transistor, is **characterized by** comprising:
a step of forming source/drain layers each including an amorphous silicon layer and a microcrystalline silicon layer sequentially stacked over a substrate;
a step of forming a channel layer over said source/drain layers; and
a step of forming a gate electrode over said channel layer, with a gate insulating film therebetween.

5. A display is **characterized by** comprising a substrate over which thin film transistors and display elements connected to said thin film transistors are formed in an arrayed manner, each of said thin film transistors including a gate electrode, a gate insulating film, a channel layer, and source/drain layers stacked over said substrate in this order or in reverse order, wherein said source/drain layers each include a microcrystalline silicon layer and an amorphous silicon layer, which are so arranged that said microcrystalline layer is on the channel layer side.
